(19) **Europäisches Patentamt / European Patent Office / Office européen des brevets**

(11) **EP 4 733 840 A1**

(12) # EUROPEAN PATENT APPLICATION
published in accordance with Art. 153(4) EPC

(43) Date of publication:
**29.04.2026 Bulletin 2026/18**

(21) Application number: **24831701.8**

(22) Date of filing: **13.06.2024**

(51) International Patent Classification (IPC):
**G03F 7/033** (2006.01)    **C08F 212/08** (2006.01)
**G03F 7/004** (2006.01)

(52) Cooperative Patent Classification (CPC):
**C08F 212/08; G03F 7/004; G03F 7/033**

(86) International application number:
**PCT/JP2024/021577**

(87) International publication number:
**WO 2025/004836 (02.01.2025 Gazette 2025/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.06.2023 JP 2023104223**

(71) Applicant: **Resonac Corporation**
**Tokyo 105-7325 (JP)**

(72) Inventors:
• **TAKAMATSU, Hiroki**
  **Tokyo 105-7325 (JP)**
• **MINAMI, Takuya**
  **Tokyo 105-7325 (JP)**
• **SAWAKI, Taku**
  **Tokyo 105-7325 (JP)**
• **TODA, Natsuki**
  **Tokyo 105-7325 (JP)**
• **YOSHIHARA, Kensuke**
  **Tokyo 105-7325 (JP)**

(74) Representative: **Strehl & Partner mbB**
**Maximilianstrasse 54**
**80538 München (DE)**

(54) **PHOTOSENSITIVE RESIN COMPOSITION, FILM-SHAPED RESIN, AND RESIN SHEET**

(57)    A photosensitive resin composition containing a polymer formed of a plurality of types of monomers is provided. A dispersion term of Hansen solubility parameters calculated based on the monomers is 16.99 or more and 17.35 or less, a number of carboxylic acids in a molecule calculated based on the monomers is 0.272 or more and 0.304 or less, a logarithmic value of an octanol/water partition coefficient calculated based on the monomers is 2.16 or more and 2.79 or less, and a glass transition temperature calculated based on the monomers is 354 K or more and 382 K or less.

**EP 4 733 840 A1**

## Description

### TECHNICAL FIELD

The present disclosure relates to a photosensitive resin composition, a film-like resin, and a resin sheet.

### BACKGROUND ART

For forming interconnects over a substrate, such as a semiconductor wafer or the like, a resin sheet having photosensitivity (which may be referred to as a "dry film resist") is used (see, for example, Patent Literature 1). In recent years, with the miniaturization of interconnects in semiconductor package substrates, there has been a demand for a dry film resist that achieves both high resolution and high adhesion.

### CITATION LIST

#### PATENT LITERATURE

Patent Literature 1: Japanese Laid-Open Patent Publication No. 2013-216804

### SUMMARY OF THE INVENTION

### PROBLEM TO BE SOLVED BY THE INVENTION

However, conventional dry film resists do not have sufficient resolution or adhesion of a polymer, and it has been challenging to form fine interconnects.

In one aspect, the present disclosure provides a photosensitive resin composition, a film-like resin, and a resin sheet that are excellent in both resolution and adhesion.

### MEANS FOR SOLVING THE PROBLEM

The present disclosure includes configurations as presented below.

<1> A photosensitive resin composition containing a polymer formed of a plurality of types of monomers, in which

a dispersion term of Hansen solubility parameters calculated based on the monomers is 16.99 or more and 17.35 or less,
a number of carboxylic acids in a molecule calculated based on the monomers is 0.272 or more and 0.304 or less,
a logarithmic value of an octanol/water partition coefficient calculated based on the monomers is 2.16 or more and 2.79 or less, and
a glass transition temperature calculated based on the monomers is 354 K or more and 382 K or less.

<2> The photosensitive resin composition according to <1>, in which

the dispersion term of the Hansen solubility parameters is 17.04 or more and 17.19 or less,
the number of the carboxylic acids is 0.273 or more and 0.290 or less,
the logarithmic value of the octanol/water partition coefficient is 2.29 or more and 2.78 or less, and
the glass transition temperature is 365 K or more and 382 K or less.

<3> The photosensitive resin composition according to <1> or <2>, in which
the monomers include acrylic acid and styrene.
<4> The photosensitive resin composition according to <1>, in which

the monomers include a third component that is different from acrylic acid and styrene, and
the third component is 3-phenoxybenzyl acrylate, 3-{2,2,6,6-tetramethyl-4-[(trimethylsilyl)oxy]-3,5-dioxa-2,4,6-trisilaheptan-4-yl}propyl 2-methylprop-2-enoate, octadecyl 2-methylprop-2-enoate, 4-hydroxyphenyl 2-methyl-2-propenoate, octadecyl 2-methylprop-2-enoate, dicyclopentanyl methacrylate, decyl prop-2-enoate, dodecyl acrylate, or 2-propenoic acid isooctadecyl ester.

<5> The photosensitive resin composition according to <2>, in which

the monomers include a third component that is different from acrylic acid and styrene, and
the third component is 10-hydroxy-2,2,4-trimethyl-4-[(trimethylsilyl)oxy]-3,8-dioxa-2,4-disilaundecan-11-yl 2-methylprop-2-enoate, hexadecyl prop-2-enoate, docosyl prop-2-enoate, 1-ethylcyclohexyl 2-methylprop-2-enoate, docosyl prop-2-enoate, tetradecyl prop-2-enoate, adamantan-1-yl 2-methylprop-2-enoate, 3-{2,2,6,6-tetramethyl-4-[(trimethylsilyl)oxy]-3,5-dioxa-2,4,6-trisilaheptan-4-yl}propyl 2-methylprop-2-enoate, or 2-propenoic acid isooctadecyl ester.

<6> The photosensitive resin composition according to <4> or <5>, wherein
an amount of the third component in the polymer is 13% by weight or more and 22% by weight or less.
<7> A film-like resin, including:
the photosensitive resin composition of any one of <1> to <6> formed into a film.
<8> A resin sheet, including:

a base; and

a resin layer formed over the base and

containing the photosensitive resin composition of any one of <1> to <6>.

ADVANTAGEOUS EFFECTS OF THE INVENTION

According to one aspect of the present disclosure, it is possible to provide a photosensitive resin composition, a film-like resin, and a resin sheet that are excellent in both resolution and adhesion.

BRIEF DESCRIPTION OF THE DRAWINGS

[FIG. 1] FIG. 1 is a table illustrating extraction results of Example 1.
[FIG. 2] FIG. 2 is a table illustrating extraction results of Example 2.
[FIG. 3] FIG. 3 is a schematic diagram illustrating an example of a film-like resin.
[FIG. 4] FIG. 4 is a schematic diagram illustrating an example of a resin sheet.
[FIG. 5] FIG. 5 is a block diagram illustrating an example of an overall configuration of a composition proposal system.
[FIG. 6] FIG. 6 is a block diagram illustrating an example of a hardware configuration of a computer.
[FIG. 7] FIG. 7 is a block diagram illustrating an example of a functional configuration of the composition proposal system.
[FIG. 8] FIG. 8 is a table illustrating an example of experimental data.
[FIG. 9] FIG. 9 is a table illustrating an example of descriptor data.
[FIG. 10] FIG. 10 is a block diagram illustrating an example of an adhesion prediction model.
[FIG. 11] FIG. 11 is a graph illustrating an example of accuracy of the adhesion prediction model.
[FIG. 12] FIG. 12 is a block diagram illustrating an example of a resolution prediction model.
[FIG. 13] FIG. 13 is a graph illustrating an example of accuracy of the resolution prediction model.
[FIG. 14] FIG. 14 is a flowchart illustrating an example of a descriptor calculation process.
[FIG. 15] FIG. 15 is a flowchart illustrating an example of a model training process.
[FIG. 16] FIG. 16 is a flowchart illustrating an example of a composition proposal process.

DESCRIPTION OF THE EMBODIMENTS

Hereinafter, embodiments of the present disclosure will be described with reference to the accompanying drawings. In the present specification and drawings, components having substantially the same functional configuration are denoted by the same reference signs, and redundant description thereof will be omitted.

[Photosensitive Resin Composition]

A photosensitive resin composition in the present embodiment is a composition used for producing a dry film resist. The photosensitive resin composition contains a polymer formed of a plurality of types of monomers. The monomers forming the polymer contain at least acrylic acid (AA) and styrene (STC). Hereinafter, the polymer contained in the photosensitive resin composition is referred to as a "base polymer".

In addition to the base polymer, the photosensitive resin composition may contain a (meth)acrylate compound, an epoxy resin, a photoinitiator, or the like. The monomers forming the base polymer may contain a third component that is different from acrylic acid and styrene.

In the present embodiment, the amount of acrylic acid is 18% by weight or more and 26% by weight or less. The amount of styrene is 60% by weight or more and 80% by weight or less. The amount of the third component is a portion of the base polymer excluding acrylic acid and styrene. That is, the amount of the third component is (100 - (amount of acrylic acid + amount of styrene)) [% by weight]. The amount of the third component is preferably 13% by weight or more and 22% by weight or less.

<Evaluation Indices>

A dry film resist produced using the photosensitive resin composition in the present embodiment has both high resolution and high adhesion. In the present embodiment, an evaluation index for resolution is "resolution 3x/x". Also, an evaluation index for adhesion is "16 $\mu$m pitch adhesion".

The resolution 3x/x is a value of the minimum x at which a pattern can be formed, where 3x denotes a line width and x denotes a space width between lines in the formation of a thin line pattern in a dry film resist. As for evaluation based on the resolution 3x/x, a smaller value of x can indicate higher resolution. The fact that the pattern can be formed can be confirmed by observing a prepared pattern using a microscope to check whether or not there is any residue or collapse of a resist.

The 16 $\mu$m pitch adhesion is the minimum line width at which a pattern can be formed in the formation of a thin line pattern in a dry film resist when a space width is widened in an evaluation pattern in which the pitch of lines is 16 $\mu$m. As for evaluation based on the 16 $\mu$m pitch adhesion, a smaller value of the line width can indicate higher adhesion. The fact that the pattern can be formed can be confirmed by observing a prepared pattern using a microscope to check whether or not there is any residue or collapse of a resist.

The 16 $\mu$m pitch adhesion may be an offset pattern adhesion. The offset pattern adhesion is the minimum line width at which a pattern can be formed in the formation of a thin line pattern in a dry film resist when a space width is widened in an evaluation pattern in which the sum of a line width and the space width is 16 $\mu$m. As for evaluation based on the offset pattern adhesion, a smaller value can indicate higher adhesion.

<Parameters>

In the photosensitive resin composition in the present embodiment, four parameters calculated based on the monomers forming the base polymer are within predetermined respective ranges. A first parameter is a dispersion term of Hansen solubility parameters (hereinafter may be referred to as "HSP_$\delta$D"). A second parameter is the number of carboxylic acids in a molecule (hereinafter may be referred to simply as "the number of carboxylic acids"). A third parameter is a logarithmic value of an octanol/water partition coefficient (hereinafter may be referred to as "logP"). A fourth parameter is a glass transition temperature (hereinafter may be referred to as "polymer Tg").

<<Dispersion Term of Hansen Solubility Parameters (HSP_$\delta$D)>>

The Hansen solubility parameters represent the strength of interaction between polymers, and thus are considered to impact resolution or adhesion. The dispersion term $\delta$D of the Hansen solubility parameters is used rather than the polarization term $\delta$P and the hydrogen bond term $\delta$H because the dispersion term $\delta$D is considered to represent the strength of interaction between benzene rings of styrene.

The HSP_$\delta$D of the base polymer is calculated through weighted addition of the HSP_$\delta$D of each monomer forming the base polymer in terms of the molar ratio. Specifically, the HSP_$\delta$D of the base polymer can be calculated according to formula (1).
[Math. 1]

$$X = \sum_i n_i x_i \quad \ldots \quad (1)$$

In the formula (1), X is the HSP_$\delta$D of the base polymer, $x_i$ is the HSP_$\delta$D of the i-th monomer, and $n_i$ is the molar ratio of the i-th monomer.

The HSP_$\delta$D of the monomer can be calculated using HSPiP or the like. HSPiP is software specialized in calculating Hansen solubility parameters.

The HSP_$\delta$D of the base polymer is preferably 16.99 or more and 17.35 or less, and more preferably 17.04 or more and 17.19 or less.

<<Number of Carboxylic Acids in Molecule>>

In a dry film resist, a carboxylic acid reacts with a base at the time of development and release. Therefore, the number of carboxylic acids in the molecule is considered to impact resolution and adhesion.

The number of carboxylic acids in the base polymer is calculated through weighted addition of the number of carboxylic acids in each monomer forming the base polymer in terms of the molar ratio. Specifically, the number of carboxylic acids in the base polymer can be calculated according to the above formula (1).

Here, in the formula (1), X is the number of carboxylic acids in the base polymer, $x_i$ is the number of carboxylic acids in the i-th monomer, and $n_i$ is the molar ratio of the i-th monomer.

The number of carboxylic acids in the monomer can be calculated using RDKit or the like. RDKit is an open-source library that is widely used in the field of cheminformatics.

The number of carboxylic acids in the base polymer is preferably 0.272 or more and 0.304 or less, and more preferably 0.273 or more and 0.290 or less.

<<Logarithmic Value of Octanol/Water Partition Coefficient (logP)>>

An aqueous solution is used for developing a dry film resist. Therefore, hydrophilicity of the base polymer is considered to impact resolution or adhesion. Also, an index indicating hydrophilicity can be an index of interaction between polymers.

The logP of the base polymer is calculated through weighted addition of the logP of each monomer forming the base polymer in terms of the molar ratio. Specifically, the logP of the base polymer can be calculated according to the above formula (1).

Here, in the formula (1), X is the logP of the base polymer, $x_i$ is the logP of the i-th monomer, and $n_i$ is the molar ratio of the i-th monomer.

The logP of the monomer can be calculated using COSMOtherm (registered trademark) or the like. COSMOtherm is thermodynamic property estimation software using a COSMO-RS method. The COSMO-RS method is a method for estimating the physical properties of a chemical substance based on the surface charges of a molecule obtained through quantum chemical calculation.

The logP of the base polymer is preferably 2.16 or more and 2.79 or less, and more preferably 2.29 or more and 2.78 or less.

<<Glass Transition Temperature (Polymer Tg) >> Polymer Tg represents mobility of a polymer chain. Therefore, the polymer Tg of the base polymer is considered to impact resolution or adhesion.

The polymer Tg of the base polymer is calculated according to a Fox formula using the polymer Tg of a homopolymer formed of each monomer forming the base polymer. Specifically, the polymer Tg of the base polymer can be calculated according to formula (2).
[Math. 2]

$$\frac{1}{TG} = \sum_i \frac{n_i}{TG_i} \quad \dots (2)$$

Here, in the formula (2), TG is the polymer Tg of a copolymer (i.e., the base polymer), $TG_i$ is the polymer Tg of a homopolymer formed of the i-th monomer, and $n_i$ is the molar ratio of the i-th monomer.

Note that the polymer Tg of the homopolymer may be a value described in literature or may be a value predicted using a trained machine learning model.

The polymer Tg of the base polymer is preferably 354 K or more and 382 K or less, and more preferably 365 K or more and 382 K or less.

<Extraction Method>

The photosensitive resin composition in the present embodiment is obtained by extracting, from a large number of candidate compositions generated in accordance with predetermined generation conditions, candidate compositions in which both the resolution 3x/x and the 16 $\mu$m pitch adhesion satisfy the respective target values. In the present embodiment, the resolution 3x/x and the 16 $\mu$m pitch adhesion are predicted using a trained machine learning model. The machine learning model and a prediction method using the machine learning model will be described below.

In the present embodiment, the generation conditions are defined as follows.

As for the amount of acrylic acid, the generation is performed in increments of 1% by weight in a range of 18% by weight or more and 26% by weight or less. That is, the generation is performed at 18% by weight, 19% by weight, 20% by weight, ... and 26% by weight, each of which is an option for the amount of acrylic acid.

As for the amount of styrene, the generation is performed in increments of 2% by weight in a range of 60% by weight or more and 80% by weight or less. That is, the generation is performed at 60% by weight, 62% by weight, 64% by weight, ... and 80% by weight, each of which is an option for the amount of styrene.

The sum of the amounts of the respective monomers is 100% by weight. That is, the amount of the third component is (100 - (amount of acrylic acid + amount of styrene)) [% by weight].

The third component is selected from options of previously provided monomers. For example, about 200 types of monomers may be included in the options.

The candidate compositions are generated in the following manner. First, all combinations of the options of the amount of acrylic acid and the options of the amount of styrene are generated. Next, for each of the combinations of the amounts, the amount of the third component is calculated. Then, for each of the combinations of the amounts, each of the options of monomers is combined as the third component. This generates all candidate compositions.

<<Example 1>>

In Example 1, the target properties were set to a 16 $\mu$m pitch adhesion of less than 4.7 and a resolution 3x/x of less than 7, thereby extracting candidate compositions in which predicted values predicted using a trained machine learning model satisfied the target properties.

In a base polymer contained in a conventionally known photosensitive resin composition, the best value of the 16 $\mu$m pitch adhesion was 4.7. Therefore, the target value of the 16 $\mu$m pitch adhesion was set to 4.7. Also, in the conventional base polymer, the best value of the resolution 3x/x was 5.5. However, a resolution 3x/x of 7 is a sufficiently high standard as a performance required for a dry film resist.

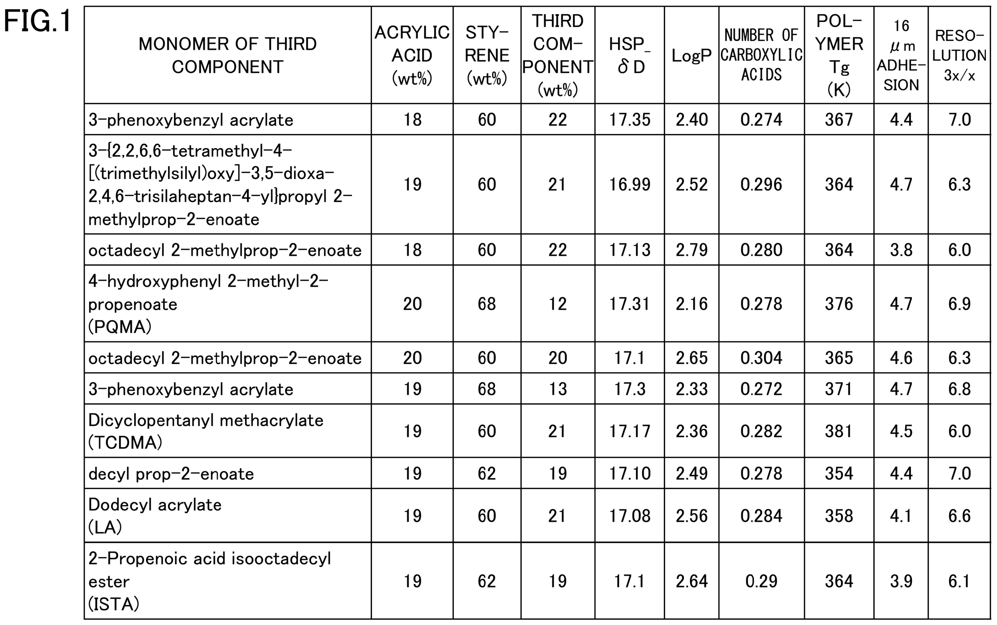

FIG. 1 is a table illustrating extraction results of Example 1. As illustrated in FIG. 1, the parameters of the candidate composition satisfying the above target properties are included in the following respective ranges.

The HSP_$\delta$D is 16.99 or more and 17.35 or less.

The number of carboxylic acids is 0.272 or more and 0.304 or less.

The logP is 2.16 or more and 2.79 or less.

The polymer Tg is 354 K or more and 382 K or less.

In the candidate compositions extracted in Example 1, the amount of the third component is 13% by weight or more and 22% by weight or less.

Also, in the candidate compositions extracted in Example 1, the third component is one of the following:

3-phenoxybenzyl acrylate;
3-{2,2,6,6-tetramethyl-4-[(trimethylsilyl)oxy]-3,5-dioxa-2,4,6-trisilaheptan-4-yl}propyl 2-methylprop-2-enoate;
octadecyl 2-methylprop-2-enoate;
4-hydroxyphenyl 2-methyl-2-propenoate (PQMA);
octadecyl 2-methylprop-2-enoate;
dicyclopentanyl methacrylate (TCDMA);
decyl prop-2-enoate;
dodecyl acrylate (LA); and
2-propenoic acid isooctadecyl ester (ISTA).

<<Example 2>>

In Example 2, the target properties were set to a 16 $\mu$m pitch adhesion of less than 4.7 and a resolution 3x/x of less than 6, thereby extracting candidate compositions in which predicted values predicted using a trained machine learning model satisfied the target properties. That is, in Example 2, candidate compositions exhibiting resolution higher than in Example 1 were extracted.

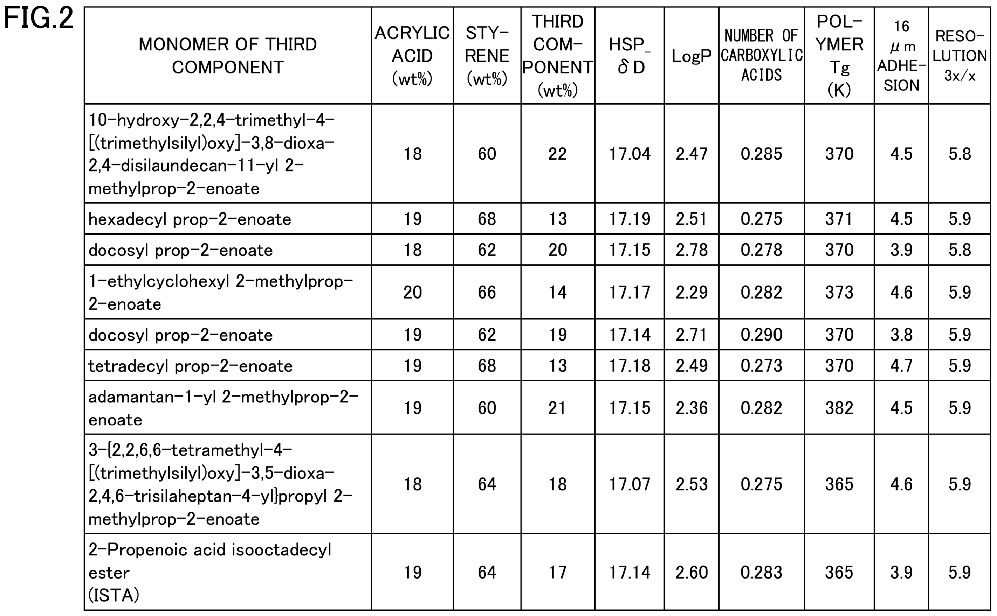

FIG. 2 is a table illustrating extraction results of Example 2. As illustrated in FIG. 2, the parameters of the candidate composition satisfying the above target properties are included in the following respective ranges.

The HSP_$\delta$D is 17.04 or more and 17.19 or less.

The number of carboxylic acids is 0.273 or more and 0.290 or less.

The logP is 2.29 or more and 2.78 or less.

The polymer Tg is 365 K or more and 382 K or less.

In the candidate compositions extracted in Example 2, the amount of the third component is 13% by weight or more and 22% by weight or less.

In the candidate compositions extracted in Example 2, the third component is one of the following:

> 10-hydroxy-2,2,4-trimethyl-4-[(trimethylsilyl)oxy]-3,8-dioxa-2,4-disilaundecan-11-yl 2-methylprop-2-enoate;
> hexadecyl prop-2-enoate;
> docosyl prop-2-enoate;
> 1-ethylcyclohexyl 2-methylprop-2-enoate;
> docosyl prop-2-enoate;
> tetradecyl prop-2-enoate;
> adamantan-1-yl 2-methylprop-2-enoate;
> 3-{2,2,6,6-tetramethyl-4-[(trimethylsilyl)oxy]-3,5-dioxa-2,4,6-trisilaheptan-4-yl}propyl 2-methylprop-2-enoate; and
> 2-propenoic acid isooctadecyl ester (ISTA).

[Film-like Resin]

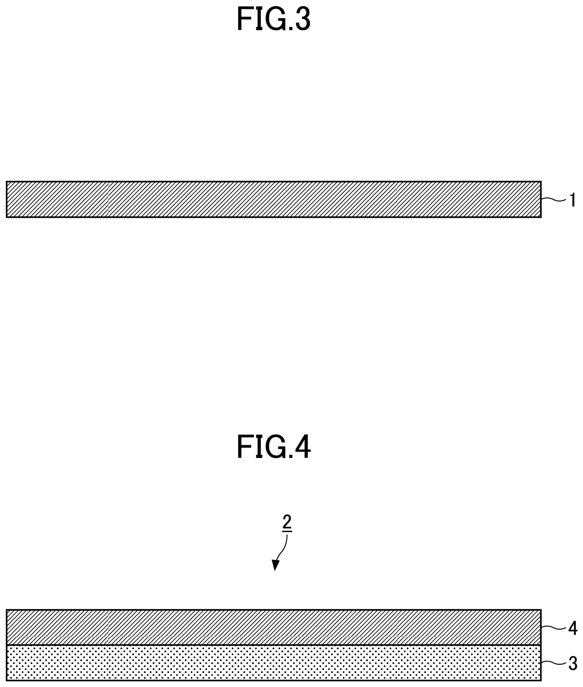

A film-like resin in the present embodiment will be described with reference to FIG. 3. FIG. 3 is a schematic diagram illustrating an example of the film-like resin.

As illustrated in FIG. 3, the film-like resin in the present embodiment is obtained by forming the photosensitive resin composition into a film. That is, a film-like resin 1 can be obtained by forming the photosensitive resin composition into a film.

[Resin Sheet]

A resin sheet in the present embodiment will be described with reference to FIG. 4. FIG. 4 is a schematic diagram illustrating an example of the resin sheet.

As illustrated in FIG. 4, a resin sheet 2 in the present embodiment includes a base 3 and a resin layer 4. The resin layer 4 is obtained by coating the photosensitive resin composition onto the base 3, followed by drying, thereby forming the photosensitive resin composition into a film. That is, the resin layer 4 is formed of the film-like resin 1, which is obtained by forming the photosensitive resin composition into a film.

[Composition Proposal System]

The composition of the base polymer contained in the photosensitive resin composition in the present embodiment is proposed by a composition proposal system or the like. The composition proposal system in the present embodiment is an information processing system configured to propose a composition of the base polymer contained in the photosensitive resin composition.

The composition proposal system predicts physical property values of the base polymer based on candidate compositions of the base polymer, and proposes candidate compositions in which the prediction results satisfy the target properties. In the present embodiment, the physical property values of the base polymer include physical property values relating to resolution and physical property values relating to adhesion. Therefore, the composition proposal system can propose candidate compositions of the base polymer that achieve both high resolution and high adhesion.

<Overall Configuration>

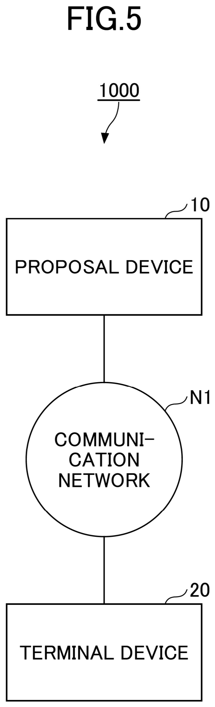

An overall configuration of the composition proposal system in the present embodiment will be described with reference to FIG. 5. FIG. 5 is a block diagram illustrating an example of the overall configuration of the composition proposal system in the present embodiment.

As illustrated in FIG. 5, a composition proposal system 1000 in the present embodiment includes a proposal device 10 and a terminal device 20. The proposal device 10 and the terminal device 20 are connected to each other via a communication network N1, such as a LAN (Local Area Network), the Internet, or the like, to enable data communication.

The proposal device 10 is an information processing device, such as a personal computer, a workstation, a server, or the like, configured to propose compositions of the base polymer contained in the photosensitive resin composition. The proposal device 10 receives proposal conditions from the terminal device 20. The proposal conditions include generation conditions for candidate compositions and target properties to be satisfied by the candidate compositions. The proposal device 10 generates the candidate compositions based on the generation conditions and predicts physical property values of the base polymer for each candidate composition. The proposal device 10 generates proposal information indicating the candidate compositions satisfying the target properties, and transmits the generated proposal information to the terminal device 20.

The terminal device 20 is an information processing terminal, such as a personal computer, a smartphone, a tablet terminal, or the like, operated by a user of the composition proposal system 1000. In response to an operation performed by the user, the terminal device 20 transmits, to the proposal device 10, the generation conditions and proposal conditions indicating the target properties. The terminal device 20 outputs, to the user, the proposal information received from the proposal device 10.

The user of the composition proposal system 1000 can refer to the proposal information output to the terminal device 20, and prepare the base polymer in accordance with candidate compositions indicated in the proposal information. Also, the user can produce a photosensitive resin composition using the base polymer prepared in accordance with the candidate compositions. The candidate composition indicated in the proposal information produces the base polymer that realizes a photosensitive resin composition having both high resolution and high adhesion. Thus, the user can produce a photosensitive resin composition, a film-like resin, and a resin sheet that have both high resolution and high adhesion.

The overall configuration of the composition proposal system 1000 illustrated in FIG. 5 is merely an example, and the composition proposal system 1000 can have various system configuration examples in accordance with applications and purposes. For example, either or both of the proposal device 10 and the terminal device 20 may be included in an amount of two or more in the composition proposal system 1000. For example, the proposal device 10 may be implemented by a plurality of computers or may be implemented as a cloud computing service. A manner to separate the devices as illustrated in FIG. 5, i.e., the proposal device 10 and the terminal device 20, is merely an example.

<Hardware Configuration>

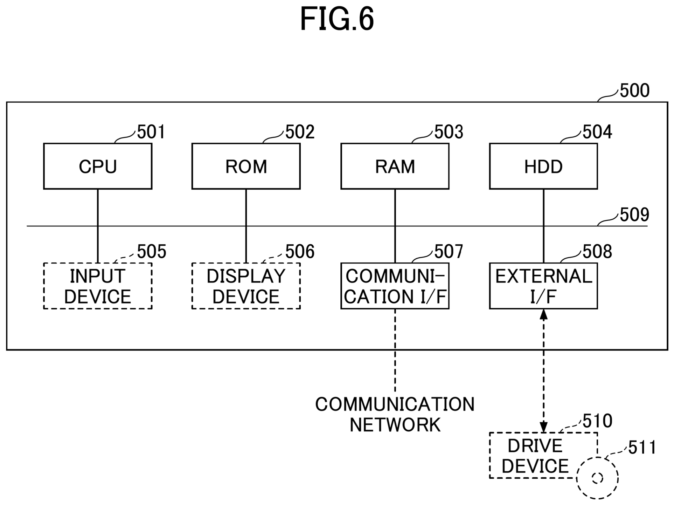

A hardware configuration of the composition proposal system 1000 in the present embodiment will be described with reference to FIG. 6.

<<Hardware Configuration of Computer>>

The proposal device 10 and the terminal device 20 in the present embodiment are implemented by a computer or the like. FIG. 6 is a block diagram illustrating an example of a hardware configuration of a computer 500 in the present embodiment.

As illustrated in FIG. 6, the computer 500 includes a CPU (Central Processing Unit) 501, a ROM (Read Only Memory) 502, a RAM (Random Access Memory) 503, an HDD (Hard Disk Drive) 504, an input device 505, a display device 506, a communication I/F (Interface) 507, and an external I/F 508. The CPU 501, ROM 502, and RAM 503 form what is referred to as a computer. The hardware components of the computer 500 are connected to each other via a bus line 509. The input device 505 and the display device 506 may be connected to the external I/F 508.

The CPU 501 is an arithmetic unit configured to read out programs and data on the RAM 503 from a storage device, such as the ROM 502, the HDD 504, or the like, followed by executing processing, thereby realizing control and functions of the overall computer 500.

The ROM 502 is an example of a nonvolatile semiconductor memory (storage device) configured to retain programs and data even after power is turned off. The ROM 502 functions as a main storage device storing various programs and data necessary for the CPU 501 to execute various programs installed in the HDD 504. Specifically, the ROM 502 stores: boot programs, such as BIOS (Basic Input/Output System), EFI (Extensible Firmware Interface), and the like, that are executed when the computer 500 is started up; and data, such as OS (Operating System) settings, network settings, and the like.

The RAM 503 is an example of a volatile semiconductor memory (storage device) in which programs and data are erased when power is turned off. The RAM 503 is, for example, DRAM (Dynamic Random Access Memory), SRAM (Static Random Access Memory), or the like. The RAM 503 provides a work area that is expanded when various programs installed in the HDD 504 are executed by the CPU 501.

The HDD 504 is an example of a nonvolatile storage device storing programs and data. The programs and data stored in the HDD 504 include, for example: an OS, which is basic software for controlling the overall computer 500; and applications for providing various functions on the OS. Instead of the HDD 504, the computer 500 may use a storage device (e.g., SSD (Solid State Drive)) that uses a flash memory as a storage medium.

The input device 505 is, for example, a component used by a user for inputting various signals, such as a touch panel, an operation key or button, a keyboard or mouse, or a microphone for inputting sound data, such as voice or the like.

The display device 506 includes, for example: a display configured to display a screen, such as a liquid crystal display, an organic EL (Electro-Luminescence) display, or the like; and a speaker configured to output sound data, such as voice or the like.

The communication I/F 507 is an interface that connects to a communication network and through which the computer 500 performs data communication.

The external I/F 508 is an interface with an external device. The external device is, for example, a drive device 510 or the like.

The drive device 510 is a device for setting of a recording medium 511. Here, the recording medium 511 includes a medium configured to optically, electrically, or magnetically record information, such as a CD-ROM, a flexible disk, a magneto-optical disk, or the like. Also, the recording medium 511 may include a semiconductor memory configured to electrically record information, such as a ROM, a flash memory, or the like. Thus, the computer 500 can perform reading from and/or writing in the recording medium 511 through the external I/F 508.

The various programs to be installed in the HDD 504 are installed, for example, by the distributed recording medium 511 being set in the drive device 510 connected to the external I/F 508, and the various programs recorded in the recording medium 511 being read out by the drive device 510. Alternatively, the various programs to be installed in the HDD 504 may be installed by being downloaded from another network different from a communication network through the communication I/F 507.

<Functional Configuration>

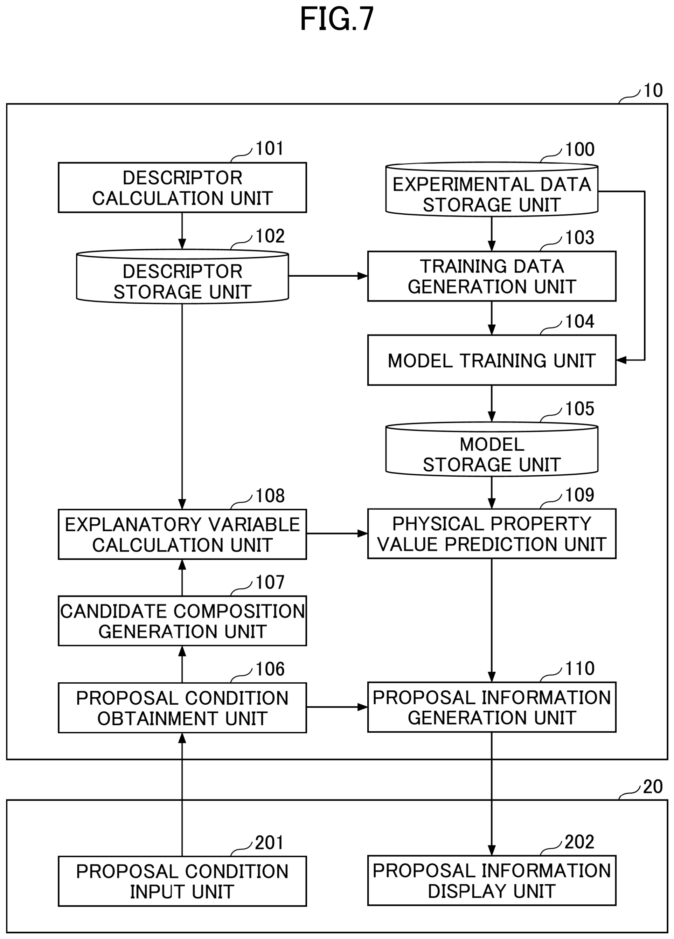

A functional configuration of the composition proposal system in the present embodiment will be described with reference to FIGS. 7 to 9. FIG. 7 is a block diagram illustrating an example of the functional configuration of the composition proposal system in the present embodiment.

<<Proposal Device>>

As illustrated in FIG. 7, the proposal device 10 in the present embodiment includes an experimental data storage unit 100, a descriptor calculation unit 101, a descriptor storage unit 102, a training data generation unit 103, a model training unit 104, a model storage unit 105, a proposal condition obtainment unit 106, a candidate composition generation unit 107, an explanatory variable calculation unit 108, a physical property value prediction unit 109, and a proposal information generation unit 110.

The experimental data storage unit 100, the descriptor storage unit 102, and the model storage unit 105 are implemented by the HDD 504 illustrated in FIG. 6.

The descriptor calculation unit 101, the training data generation unit 103, the model training unit 104, the proposal condition obtainment unit 106, the candidate composition generation unit 107, the explanatory variable calculation unit 108, the physical property value prediction unit 109, and the proposal information generation unit 110 are implemented by a process executed by the CPU 501 in accordance with a program developed from the HDD 504 on the RAM 503 illustrated in FIG. 6.

The experimental data storage unit 100 stores experimental data indicating experimental results relating to various dry film resists. The experimental data is data in which information indicating dry film resists that were used in experiments, compositions (experimental compositions) of the base polymers contained in the dry film resists, and physical property values (experimental values) observed in the experiments are associated with each other.

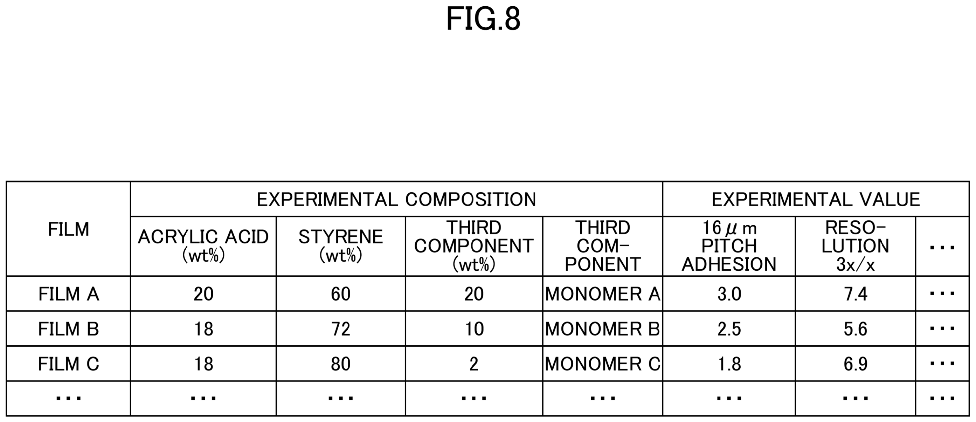

FIG. 8 is a table illustrating an example of experimental data in the present embodiment. As illustrated in FIG. 8, the experimental data includes, as data items, information (films) indicating the dry film resists that were used in the experiments, experimental compositions, experimental values, and the like. The experimental compositions include the amount of acrylic acid, the amount of styrene, the amount of the third component, and identification information for identifying a monomer serving as the third component. The experimental values include the 16 $\mu$m pitch adhesion and the resolution 3x/x.

The identification information is, for example, a compound name, a structural formula, SMILES (Simplified Molecular Input Line Entry System) information, ECFP (Extended Connectivity Circular Fingerprints) information, or the like. The identification information is not limited to these, and any information capable of identifying a monomer can be used.

The description continues with reference to FIG. 7. The descriptor calculation unit 101 calculates descriptors relating to monomers that can form the base polymer. In the present embodiment, the descriptor calculation unit 101 is previously provided with a list of monomers for which descriptors are to be calculated, and is assumed to be stored in a storage unit, such as the HDD 504 or the like. The list of monomers includes acrylic acid, styrene, and the third component. The descriptors relating to monomers include HSP_$\delta$D, the number of carboxylic acids, logP, and polymer Tg relating to each monomer. The descriptor calculation unit 101 generates descriptor data in which the descriptors relating to monomers are associated with the identification information for identifying the monomers.

The descriptor storage unit 102 stores the descriptor data generated by the descriptor calculation unit 101.

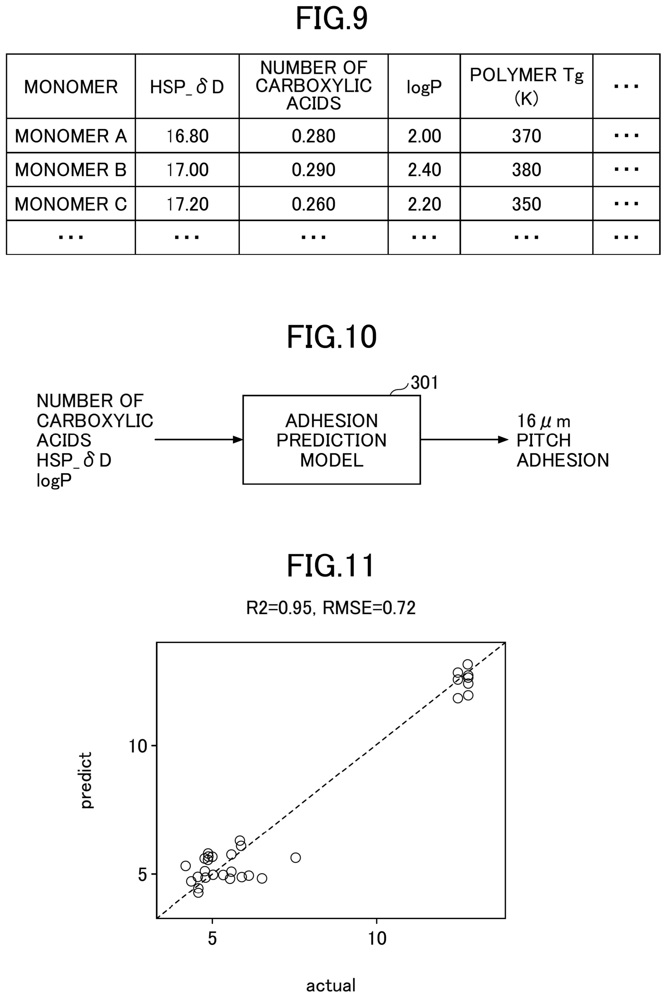

FIG. 9 is a table illustrating an example of the descriptor data in the present embodiment. As illustrated in FIG. 9, the descriptor data includes, as data items, identification information for identifying monomers, HSP_$\delta$D, the number of carboxylic acids, logP, and polymer Tg. The descriptor data may include data items for storing other descriptors.

The description continues with reference to FIG. 7. The training data generation unit 103 generates training data for training a prediction model. The prediction model is a machine learning model configured to predict physical property values of the base polymer.

Specifically, the training data generation unit 103 calculates explanatory variables relating to the experimental compositions based on the experimental compositions included in the experimental data read out from the experimental data storage unit 100. The explanatory variables relating to the experimental compositions include HSP_$\delta$D, the number of carboxylic acids, logP, and polymer Tg. The training data generation unit 103 calculates HSP_$\delta$D, the number of carboxylic acids, logP, and polymer Tg relating to the experimental composition through weighted addition of HSP_$\delta$D, the number of carboxylic acids, logP, and polymer Tg of the monomer read out from the descriptor storage unit 102 in terms of the amount of each monomer contained in the experimental composition.

Next, the training data generation unit 103 obtains experimental values included in the experimental data. Specifically, the training data generation unit 103 obtains the 16 μm pitch adhesion and the resolution 3x/x included in the experimental data. Then, the training data generation unit 103 generates training data relating to the experimental composition by combining the explanatory variables relating to the experimental composition with the experimental values serving as ground truth value of an objective variable.

The model training unit 104 trains prediction models based on the training data generated by the training data generation unit 103. The prediction model includes: a prediction model configured to predict a physical property value indicating resolution (i.e. the resolution 3x/x) (hereinafter this prediction model is referred to as a "resolution prediction model"); and a prediction model configured to predict a physical property value indicating adhesion (i.e. the 16 μm pitch adhesion) (hereinafter this prediction model is referred to as an "adhesion prediction model").

The model storage unit 105 stores trained prediction models generated by the model training unit 104. That is, the model storage unit 105 stores the resolution prediction model that has been trained, and the adhesion prediction model that has been trained.

The proposal condition obtainment unit 106 obtains proposal conditions indicating conditions relating to the compositions of the base polymer. The proposal condition obtainment unit 106 may obtain the proposal conditions by receiving information indicating the proposal conditions from the terminal device 20. Alternatively, the proposal condition obtainment unit 106 may obtain the proposal conditions by receiving the proposal conditions input from the input device 505. Alternatively, the proposal condition obtainment unit 106 may obtain the proposal conditions by reading out the proposal conditions previously stored in a storage unit, such as the HDD 504 or the like.

The proposal conditions include generation conditions of candidate compositions and target properties to be satisfied by the candidate compositions. The generation conditions include a condition relating to the amount of acrylic acid, a condition relating to the amount of styrene, and a list of monomers to be used as the third component. The target properties include a target value for the physical property value relating to resolution and a target value for the physical property value indicating adhesion. All or some of the proposal conditions may be previously defined, and stored in the storage unit.

The candidate composition generation unit 107 generates candidate compositions based on the generation conditions included in the proposal conditions obtained by the proposal condition obtainment unit 106. Specifically, the candidate composition generation unit 107 generates options of the amount of acrylic acid and options of the amount of styrene in accordance with the generation conditions. Next, the candidate composition generation unit 107 combines the amount of acrylic acid and the amount of styrene, and calculates the amount of the third component. Then, the candidate composition generation unit 107 combines each of the monomers included in the list, i.e., the third component, with the combinations of the amounts. This generates all candidate compositions.

The explanatory variable calculation unit 108 calculates, based on the candidate compositions generated by the candidate composition generation unit 107, explanatory variables relating to the candidate compositions. A method in which the explanatory variable calculation unit 108 calculates the explanatory variables is similar to the method in which the training data generation unit 103 calculates the explanatory variables.

The physical property value prediction unit 109 predicts physical property values relating to the candidate compositions by inputting the explanatory variables, calculated by the explanatory variable calculation unit 108, into the prediction model read out from the model storage unit 105. Specifically, the physical property value prediction unit 109 predicts physical property values relating to resolution by inputting the explanatory variables relating to the candidate compositions into the trained resolution prediction model. Next, the physical property value prediction unit 109 predicts physical property values relating to adhesion by inputting the explanatory variables relating to the candidate compositions into the trained adhesion prediction model.

The proposal information generation unit 110 generates proposal information based on the physical property value predicted by the physical property value prediction unit 109. The proposal information generation unit 110 transmits the proposal information to the terminal device 20.

The proposal information includes information relating to the candidate compositions in which the physical property values predicted by the physical property value prediction unit 109 satisfy the target properties included in the proposal conditions. The proposal information may include information relating to the candidate compositions in which the physical property values predicted by the physical property value prediction unit 109 do not satisfy the target properties included in the proposal conditions.

For example, the proposal information generation unit 110 may extract candidate compositions in which the physical property values satisfy the target properties, and generate proposal information in which the extracted candidate compositions are arranged according to a predetermined rule (e.g., in an ascending or descending order of the physical property value, or in an ascending or descending order of the amount of a specific monomer). Also, for example, the proposal information generation unit 110 may generate proposal information in which all candidate compositions are arranged in an order of the quality of the physical property values.

<<Terminal Device>>

As illustrated in FIG. 7, the terminal device 20 in the present embodiment includes a proposal condition input unit 201 and a proposal information display unit 202.

The proposal condition input unit 201 and the proposal information display unit 202 are implemented by a process executed by the CPU 501 in accordance with a program developed on the RAM 503 from the HDD 504 illustrated in FIG. 6.

The proposal condition input unit 201 receives an input of proposal conditions in accordance with an operation of a user. The proposal condition input unit 201 transmits information indicating the received proposal conditions to the proposal device 10.

The proposal information display unit 202 receives the proposal information from the proposal device 10. The proposal information display unit 202 outputs the received proposal information on the display device 506.

<Prediction Model>

The prediction models in the present embodiment will be described in more detail with reference to FIGS. 10 to 13.

FIG. 10 is a block diagram illustrating an example of the adhesion prediction model. As illustrated in FIG. 10, an adhesion prediction model 301 is a machine learning model in which the number of carboxylic acids, HSP_$\delta$D, and logP are explanatory variables, and the 16 $\mu$m pitch adhesion is an objective variable.

The adhesion prediction model 301 is, as an example, a machine learning model based on Gaussian process regression. When a kernel function is implemented in scikit-learn, ConstantKernel() * RBF(np.ones (3)) + WhiteKernel() can be used as an example. Note that scikit-learn is an open-source machine learning library.

FIG. 11 is a graph illustrating an example of prediction accuracy of the adhesion prediction model. FIG. 11 is the results obtained by evaluating the prediction accuracy of the trained adhesion prediction model 301 through cross-validation. Here, a coefficient of determination ($R^2$) and a root mean squared error (RMSE) were used as evaluation indices. As illustrated in FIG. 11, the $R^2$ was 0.95 and the RMSE was 0.72. FIG. 11 shows that the adhesion prediction model 301 can predict the 16 $\mu$m pitch adhesion with high accuracy.

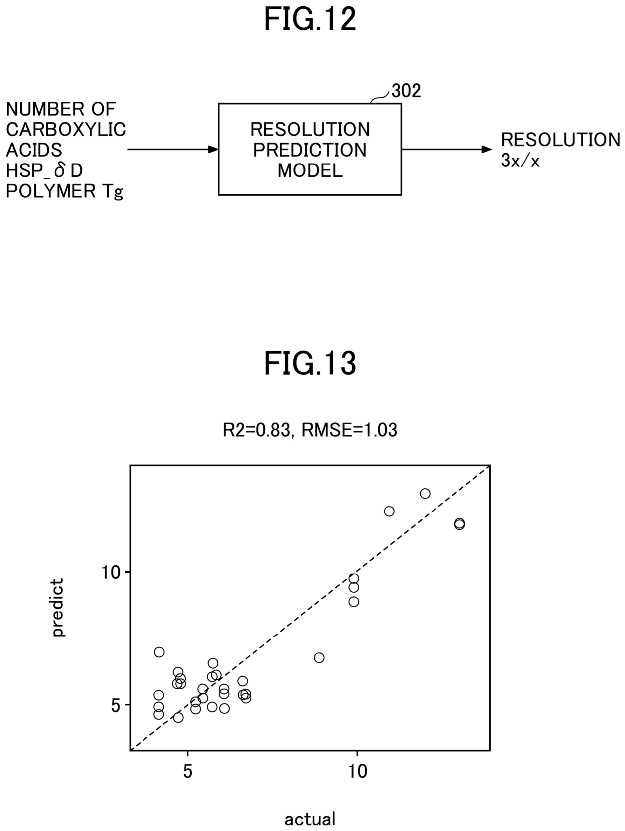

FIG. 12 is a block diagram illustrating an example of the resolution prediction model. As illustrated in FIG. 12, the resolution prediction model 302 is a machine learning model in which the number of carboxylic acids, HSP_$\delta$D, and polymer Tg are explanatory variables, and the resolution 3x/x is an objective variable.

The resolution prediction model 302 is, as an example, a machine learning model based on Gaussian process regression. When a kernel function is implemented in scikit-learn, ConstantKernel() * RBF() + WhiteKernel() can be used as an example.

FIG. 13 is a graph illustrating an example of prediction accuracy of the resolution prediction model. FIG. 13 is the results obtained by evaluating the prediction accuracy of the trained resolution prediction model 302 through cross-validation. Here, as in FIG. 11, the $R^2$ and the RMSE were used as evaluation indices. As illustrated in FIG. 13, the $R^2$ was 0.83 and the RMSE was 1.03. FIG. 13 shows that the resolution prediction model 302 can predict the resolution 3x/x with high accuracy.

<Processing Procedure>

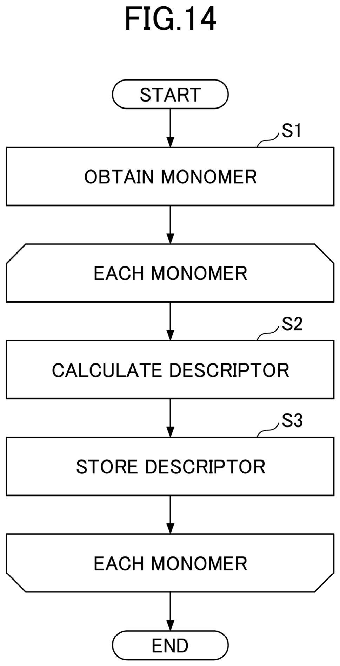

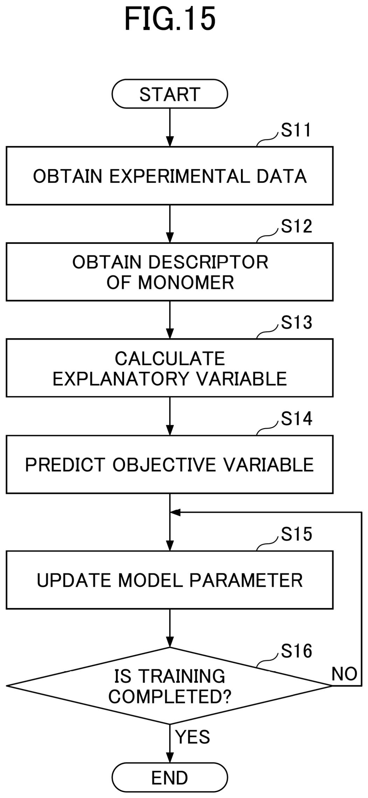

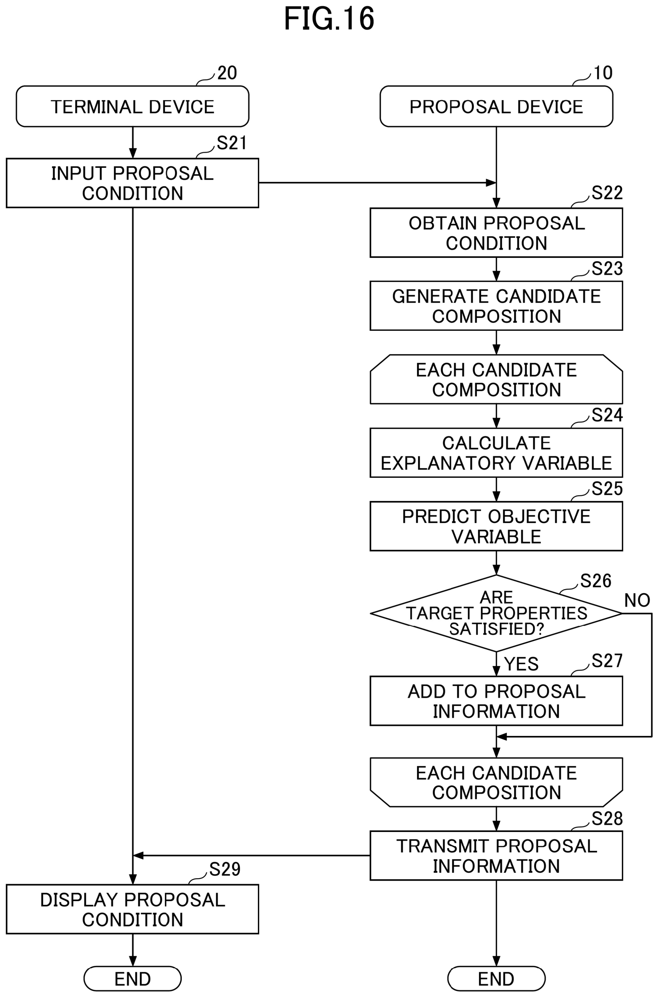

A processing procedure of a proposal method executed by the composition proposal system 1000 in the present embodiment will be described with reference to FIGS. 14 to 16. The proposal method in the present embodiment includes a descriptor calculation process (see FIG. 14), a model training process (see FIG. 15), and a composition proposal process (see FIG. 16).

<<Descriptor Calculation Process>>

FIG. 14 is a flowchart illustrating an example of the descriptor calculation process in the present embodiment. The descriptor calculation process is a process for generating descriptor data relating to monomers.

In step S1, the descriptor calculation unit 101 of the proposal device 10 reads out a list of monomers from a storage unit. Next, the descriptor calculation unit 101 obtains, from the read-out list, monomers to be calculated for descriptors.

In step S2, the descriptor calculation unit 101 of the proposal device 10 calculates descriptors relating to the monomers obtained in step S1. Specifically, the descriptor calculation unit 101 calculates HSP_$\delta$D, the number of carboxylic acids, logP, and polymer Tg relating to the monomers.

In step S3, the descriptor calculation unit 101 of the proposal device 10 associates identification information for identifying the monomers with the descriptors calculated in step S2. This generates descriptor data. Next, the descriptor calculation unit 101 stores the descriptor data in the descriptor storage unit 102.

The process from step S2 to step S3 is repeatedly executed for all the polymers included in the list read out in step S1.

<<Model Training Process>>

FIG. 15 is a flowchart illustrating an example of the model training process in the present embodiment. The model training process is a process for training a prediction model.

In step S11, the training data generation unit 103 of the proposal device 10 reads out experimental data from the experimental data storage unit 100. Next, the training data generation unit 103 selects, from the experimental data, experimental compositions to be used for training.

In step S12, the training data generation unit 103 of the proposal device 10 reads out, from the descriptor storage unit 102, descriptor data relating to each monomer included in the experimental compositions selected in step S11. Next, the training data generation unit 103 obtains, from the read-out descriptor data, HSP_$\delta$D, the number of carboxylic acids, logP, and polymer Tg.

In step S13, the training data generation unit 103 of the proposal device 10 calculates explanatory variables relating to the experimental compositions based on the descriptors obtained in step S12. Specifically, the training data generation unit 103 performs weighted addition of HSP_$\delta$D, the number of carboxylic acids, logP, and polymer Tg relating to the monomers based on the amount of each monomer included in the experimental compositions. Thus, HSP_$\delta$D, the number of carboxylic acids, logP, and polymer Tg relating to the experimental compositions are calculated.

Then, the training data generation unit 103 obtains experimental values corresponding to the experimental compositions selected in step S11. Specifically, the training data generation unit 103 obtains the 16 $\mu$m pitch adhesion and the resolution 3x/x included in the experimental data. Next, the training data generation unit 103 combines the experimental values, serving as ground truth value of the objective variable, with the explanatory variables relating to the experimental compositions. This generates training data relating to the experimental compositions. The training data generation unit 103 transmits the training data relating to the experimental compositions to the model training unit 104.

In step S14, the model training unit 104 of the proposal device 10 receives the training data relating to the experimental compositions from the training data generation unit 103. Next, the model training unit 104 inputs the explanatory variables included in the training data to the prediction model under training, thereby predicting the physical property values relating to the experimental compositions.

Specifically, first, the model training unit 104 inputs the number of carboxylic acids, HSP_$\delta$D, and logP included in the training data to the adhesion prediction model under training. The adhesion prediction model predicts the 16 $\mu$m pitch adhesion based on the input number of carboxylic acids, HSP_$\delta$D, and logP, and outputs a predicted value of the 16 $\mu$m pitch adhesion.

Next, the model training unit 104 inputs the number of carboxylic acids, HSP_$\delta$D, and polymer Tg included in the training data to the resolution prediction model under training. The resolution prediction model predicts the resolution 3x/x based on the input number of carboxylic acids, HSP_$\delta$D, and polymer Tg, and outputs a predicted value of the resolution 3x/x.

In step S15, the model training unit 104 of the proposal device 10 calculates an error between the predicted value predicted in step S14 and the ground truth value included in the training data. Next, the model training unit 104 updates parameters of the prediction model to minimize the error between the predicted value and the ground truth value.

Specifically, the model training unit 104 calculates an error between the predicted value of the 16 $\mu$m pitch adhesion output from the adhesion prediction model in step S14 and the ground truth value of the 16 $\mu$m pitch adhesion included in the training data, and updates the parameters of the adhesion prediction model to minimize the error. Also, the model training unit 104 calculates an error between the predicted value of the resolution 3x/x output from the resolution prediction model in step S14 and the ground truth value of the resolution 3x/x included in the training data, and updates the parameters of the resolution prediction model to minimize the error.

In step S16, the model training unit 104 of the proposal device 10 determines whether or not the training is completed. Whether or not the training is completed may be determined based on whether or not the error calculated in step S14 has converged or whether or not a predetermined number of repetitions has been exceeded. If the training is not completed (NO), the model training unit 104 returns the process to step S15. If the training is not completed (NO), the model training unit 104 may return the process to step S11 to further obtain experimental data. In this case, the training data generation unit 103 selects a different experimental composition and executes the process from step S15 to step S16 again. If the training is completed (YES), the model training unit 104 ends the model training process.

<<Composition Proposal Process>>

FIG. 16 is a flowchart illustrating an example of the composition proposal process in the present embodiment. The composition proposal process is a process for proposing candidate compositions that satisfy the target properties based on the trained prediction models.

In step S21, the proposal condition input unit 201 of the terminal device 20 receives an input of proposal conditions in accordance with an operation of a user. The proposal conditions include generation conditions for candidate compositions and target properties to be satisfied by the candidate compositions. All or some of the proposal conditions may be previously defined. When all the proposal conditions are previously defined, the process of step S21 may be skipped.

When receiving the proposal conditions, the proposal condition input unit 201 transmits information indicating the proposal conditions to the proposal device 10. In the proposal device 10, the proposal condition obtainment unit 106 receives information indicating the proposal condition from the terminal device 20.

In step S22, the proposal condition obtainment unit 106 of the proposal device 10 obtains generation conditions included in the information indicating the proposal conditions, and transmits the obtained generation conditions to the candidate composition generation unit 107. Also, the proposal condition obtainment unit 106 obtains the target properties included in the information indicating the proposal conditions, and transmits the obtained target properties to the proposal information generation unit 110.

In step S23, the candidate composition generation unit 107 of the proposal device 10 receives the generation conditions from the proposal condition obtainment unit 106. Next, the candidate composition generation unit 107 generates candidate compositions based on the generation conditions. The candidate composition generation unit 107 transmits the generated candidate compositions to the explanatory variable calculation unit 108.

In step S24, the explanatory variable calculation unit 108 of the proposal device 10 receives the candidate compositions from the candidate composition generation unit 107. Next, the explanatory variable calculation unit 108 calculates explanatory variables relating to the candidate compositions based on the candidate compositions. A method of calculating the explanatory variables is similar to the method in which the training data generation unit 103 calculates the explanatory variables in step S13. The explanatory variable calculation unit 108 transmits the explanatory variables relating to the candidate composition to the physical property value prediction unit 109.

In step S25, the physical property value prediction unit 109 of the proposal device 10 receives the explanatory variables relating to the candidate compositions from the explanatory variable calculation unit 108. Next, the physical property value prediction unit 109 reads out the trained adhesion prediction model and the trained resolution prediction model from the model storage unit 105.

Subsequently, the physical property value prediction unit 109 inputs the number of carboxylic acids, HSP_$\delta$D, and logP relating to the candidate composition to the trained adhesion prediction model. The adhesion prediction model predicts the 16 $\mu$m pitch adhesion based on the input number of carboxylic acids, HSP_$\delta$D, and logP, and outputs a predicted value of the 16 $\mu$m pitch adhesion.

The physical property value prediction unit 109 inputs the number of carboxylic acids, HSP_$\delta$D, and polymer Tg relating to the candidate composition to the trained resolution prediction model. The resolution prediction model predicts the resolution 3x/x based on the input number of carboxylic acids, HSP_$\delta$D, and polymer Tg, and outputs a predicted value of the resolution 3x/x.

Then, the physical property value prediction unit 109 transmits the physical property values relating to the candidate compositions to the proposal information generation unit 110. Specifically, the physical property value prediction unit 109 transmits, to the proposal information generation unit 110, the predicted value of the 16 $\mu$m pitch adhesion output by the adhesion prediction model and the predicted value of the resolution 3x/x output by the resolution prediction model.

In step S26, the proposal information generation unit 110 of the proposal device 10 receives the target properties from the proposal condition obtainment unit 106. Also, the proposal information generation unit 110 receives the physical property values relating to the candidate compositions from the physical property value prediction unit 109.

Next, the proposal information generation unit 110 determines whether or not the physical property values relating to the candidate compositions satisfy the target properties. Specifically, the proposal information generation unit 110 determines whether or not the predicted value of the 16 $\mu$m pitch adhesion is less than the target value of the 16 $\mu$m pitch adhesion included in the target properties. Also, the proposal information generation unit 110 determines whether or not the predicted value of the resolution 3x/x is less than the target value of the resolution 3x/x included in the target properties.

When both the predicted value of the 16 $\mu$m pitch adhesion and the predicted value of the resolution 3x/x are less than the respective target values, the proposal information generation unit 110 determines that the physical property values relating to the candidate compositions satisfy the target properties. When at least one of the predicted value of the 16 $\mu$m pitch adhesion or the predicted value of the resolution 3x/x is equal to or more than the target value, the proposal information generation unit 110 determines that the physical property values relating to the candidate compositions do not satisfy the target properties.

When it is determined that the physical property values relating to the candidate compositions satisfy the target properties (YES), the proposal information generation unit 110 causes the process to proceed to step S27. Conversely, when it is determined that the physical property values relating to the candidate compositions do not satisfy the target properties (NO), the proposal information generation unit 110 skips step S27.

If candidate compositions not satisfying the target properties are included in the proposal information, step S26 may be skipped.

In step S27, the proposal information generation unit 110 of the proposal device 10 adds, to the proposal information, information relating to the candidate compositions in which the physical property values are determined to satisfy the target properties. The proposal information includes the candidate compositions and the physical property values. The candidate compositions include the amount of acrylic acid, the amount of styrene, the amount of the third component, and identification information for identifying a monomer serving as the third component. The physical property values include the predicted value of the 16 $\mu$m pitch adhesion and the predicted value of the resolution 3x/x.

The process from step S24 to step S27 is repeatedly executed for all the candidate compositions generated in step S23.

In step S28, the proposal information generation unit 110 of the proposal device 10 transmits the proposal information to the terminal device 20. In the terminal device 20, the proposal information display unit 202 receives the proposal information from the proposal device 10.

In step S29, the proposal information display unit 202 of the terminal device 20 displays the proposal information on the display device 506. A user can produce the base polymer to be contained in the photosensitive resin composition with reference to the proposal information displayed on the display device 506 of the terminal device 20 and in accordance with the candidate composition indicated in the displayed proposal information. The user can search for a more appropriate composition of the base polymer by studying the proposal information displayed on the display device 506 of the terminal device 20 and inputting new proposal conditions.

<Effects of Embodiments>

The photosensitive resin composition in the present embodiment contains the polymer formed of a plurality of types of monomers, and the predetermined explanatory variables calculated based on the monomers are included in the predetermined respective ranges. The predetermined ranges are determined based on the compositions in which the prediction results of the machine learning model, in which the physical property value relating to resolution and the physical property value relating to adhesion are objective variables, satisfy the predetermined target values. Therefore, according to the present embodiment, a photosensitive resin composition, a film-like resin, and a resin sheet that are excellent in resolution and adhesion are provided.

The proposal device 10 in the present embodiment predicts, based on the trained prediction model, the physical property values relating to resolution and the physical property values relating to adhesion of the candidate compositions generated based on the predetermined generation conditions, and proposes candidate compositions in which the prediction results satisfy the predetermined target properties. Therefore, according to the present embodiment, it is possible to propose a composition of the base polymer that achieves a photosensitive resin composition that is excellent in resolution and adhesion.

Although the embodiments of the present disclosure have been described above in detail, the embodiments disclosed herein are exemplary and not restrictive in all respects. The embodiments can be modified and improved in various forms without departing from the scope and intent of claims recited. The matters described in the above embodiments may have other configurations as long as there is no contradiction, and may be combined as long as there is no contradiction.

This application claims priority to Japanese Patent Application No. 2023-104223 filed with the Japan Patent Office on June 26, 2023, and is incorporated herein by reference in its entirety.

REFERENCE SIGNS LIST

| 1 | Film-like resin |
|---|---|
| 2 | Resin sheet |
| 3 | Base |
| 4 | Resin layer |
| 10 | Proposal device |
| 100 | Experimental data storage unit |
| 101 | Descriptor calculation unit |
| 102 | Descriptor storage unit |
| 103 | Training data generation unit |
| 104 | Model training unit |
| 105 | Model storage unit |
| 106 | Proposal condition obtainment unit |
| 107 | Candidate composition generation unit |
| 108 | Explanatory variable calculation unit |
| 109 | Physical property prediction unit |
| 110 | Proposal information generation unit |
| 20 | Terminal device |
| 201 | Proposal condition input unit |
| 202 | Proposal information display unit |
| 1000 | Composition proposal system |

**Claims**

1. A photosensitive resin composition containing a polymer formed of a plurality of types of monomers, wherein

   a dispersion term of Hansen solubility parameters calculated based on the monomers is 16.99 or more and 17.35 or less,
   a number of carboxylic acids in a molecule calculated based on the monomers is 0.272 or more and 0.304 or less,
   a logarithmic value of an octanol/water partition coefficient calculated based on the monomers is 2.16 or more and 2.79 or less, and
   a glass transition temperature calculated based on the monomers is 354 K or more and 382 K or less.

2. The photosensitive resin composition according to claim 1, wherein

   the dispersion term of the Hansen solubility parameters is 17.04 or more and 17.19 or less,
   the number of the carboxylic acids is 0.273 or more and 0.290 or less,
   the logarithmic value of the octanol/water partition coefficient is 2.29 or more and 2.78 or less, and
the glass transition temperature is 365 K or more and 382 K or less.

3. The photosensitive resin composition according to claim 1 or 2, wherein
the monomers include acrylic acid and styrene.

4. The photosensitive resin composition according to claim 1, wherein

the monomers include a third component that is different from acrylic acid and styrene, and
the third component is 3-phenoxybenzyl acrylate, 3-{2,2,6,6-tetramethyl-4-[(trimethylsilyl)oxy]-3,5-dioxa-2,4,6-trisilaheptan-4-yl}propyl 2-methylprop-2-enoate, octadecyl 2-methylprop-2-enoate, 4-hydroxyphenyl 2-methyl-2-propenoate, octadecyl 2-methylprop-2-enoate, dicyclopentanyl methacrylate, decyl prop-2-enoate, dodecyl acrylate, or 2-propenoic acid isooctadecyl ester.

5. The photosensitive resin composition according to claim 2, wherein

the monomers include a third component that is different from acrylic acid and styrene, and
the third component is 10-hydroxy-2,2,4-trimethyl-4-[(trimethylsilyl)oxy]-3,8-dioxa-2,4-disilaundecan-11-yl 2-methylprop-2-enoate, hexadecyl prop-2-enoate, docosyl prop-2-enoate, 1-ethylcyclohexyl 2-methylprop-2-enoate, docosyl prop-2-enoate, tetradecyl prop-2-enoate, adamantan-1-yl 2-methylprop-2-enoate, 3-{2,2,6,6-tetramethyl-4-[(trimethylsilyl)oxy]-3,5-dioxa-2,4,6-trisilaheptan-4-yl}propyl 2-methylprop-2-enoate, or 2-propenoic acid isooctadecyl ester.

6. The photosensitive resin composition according to claim 4 or 5, wherein
an amount of the third component in the polymer is 13% by weight or more and 22% by weight or less.

7. A film-like resin, comprising:
the photosensitive resin composition of any one of claims 1 to 6 formed into a film.

8. A resin sheet, comprising:

a base; and
a resin layer formed over the base and containing the photosensitive resin composition of any one of claims 1 to 6.

FIG.1

| MONOMER OF THIRD COMPONENT | ACRYLIC ACID (wt%) | STY-RENE (wt%) | THIRD COM-PONENT (wt%) | HSP$_{\delta D}$ | LogP | NUMBER OF CARBOXYLIC ACIDS | POL-YMER Tg (K) | 16 $\mu$m ADHE-SION | RESO-LUTION 3x/x |
|---|---|---|---|---|---|---|---|---|---|
| 3-phenoxybenzyl acrylate | 18 | 60 | 22 | 17.35 | 2.40 | 0.274 | 367 | 4.4 | 7.0 |
| 3-[2,2,6,6-tetramethyl-4-[(trimethylsilyl)oxy]-3,5-dioxa-2,4,6-trisilaheptan-4-yl]propyl 2-methylprop-2-enoate | 19 | 60 | 21 | 16.99 | 2.52 | 0.296 | 364 | 4.7 | 6.3 |
| octadecyl 2-methylprop-2-enoate | 18 | 60 | 22 | 17.13 | 2.79 | 0.280 | 364 | 3.8 | 6.0 |
| 4-hydroxyphenyl 2-methyl-2-propenoate (PQMA) | 20 | 68 | 12 | 17.31 | 2.16 | 0.278 | 376 | 4.7 | 6.9 |
| octadecyl 2-methylprop-2-enoate | 20 | 60 | 20 | 17.1 | 2.65 | 0.304 | 365 | 4.6 | 6.3 |
| 3-phenoxybenzyl acrylate | 19 | 68 | 13 | 17.3 | 2.33 | 0.272 | 371 | 4.7 | 6.8 |
| Dicyclopentanyl methacrylate (TCDMA) | 19 | 60 | 21 | 17.17 | 2.36 | 0.282 | 381 | 4.5 | 6.0 |
| decyl prop-2-enoate | 19 | 62 | 19 | 17.10 | 2.49 | 0.278 | 354 | 4.4 | 7.0 |
| Dodecyl acrylate (LA) | 19 | 60 | 21 | 17.08 | 2.56 | 0.284 | 358 | 4.1 | 6.6 |
| 2-Propenoic acid isooctadecyl ester (ISTA) | 19 | 62 | 19 | 17.1 | 2.64 | 0.29 | 364 | 3.9 | 6.1 |

FIG.2

| MONOMER OF THIRD COMPONENT | ACRYLIC ACID (wt%) | STY-RENE (wt%) | THIRD COM-PONENT (wt%) | HSP δ D | LogP | NUMBER OF CARBOXYLIC ACIDS | POL-YMER Tg (K) | 16 μm ADHE-SION | RESO-LUTION 3x/x |
|---|---|---|---|---|---|---|---|---|---|
| 10-hydroxy-2,2,4-trimethyl-4-[(trimethylsilyl)oxy]-3,8-dioxa-2,4-disilaundecan-11-yl 2-methylprop-2-enoate | 18 | 60 | 22 | 17.04 | 2.47 | 0.285 | 370 | 4.5 | 5.8 |
| hexadecyl prop-2-enoate | 19 | 68 | 13 | 17.19 | 2.51 | 0.275 | 371 | 4.5 | 5.9 |
| docosyl prop-2-enoate | 18 | 62 | 20 | 17.15 | 2.78 | 0.278 | 370 | 3.9 | 5.8 |
| 1-ethylcyclohexyl 2-methylprop-2-enoate | 20 | 66 | 14 | 17.17 | 2.29 | 0.282 | 373 | 4.6 | 5.9 |
| docosyl prop-2-enoate | 19 | 62 | 19 | 17.14 | 2.71 | 0.290 | 370 | 3.8 | 5.9 |
| tetradecyl prop-2-enoate | 19 | 68 | 13 | 17.18 | 2.49 | 0.273 | 370 | 4.7 | 5.9 |
| adamantan-1-yl 2-methylprop-2-enoate | 19 | 60 | 21 | 17.15 | 2.36 | 0.282 | 382 | 4.5 | 5.9 |
| 3-{2,2,6,6-tetramethyl-4-[(trimethylsilyl)oxy]-3,5-dioxa-2,4,6-trisilaheptan-4-yl}propyl 2-methylprop-2-enoate | 18 | 64 | 18 | 17.07 | 2.53 | 0.275 | 365 | 4.6 | 5.9 |
| 2-Propenoic acid isooctadecyl ester (ISTA) | 19 | 64 | 17 | 17.14 | 2.60 | 0.283 | 365 | 3.9 | 5.9 |

EP 4 733 840 A1

# FIG.3

~ 1

# FIG.4

$\underline{2}$

~ 4

~ 3

# FIG.5

1000

PROPOSAL DEVICE — 10

COMMUNI-CATION NETWORK — N1

TERMINAL DEVICE — 20

# FIG.6

# FIG.7

10

| 101 | 100 |
|---|---|
| DESCRIPTOR CALCULATION UNIT | EXPERIMENTAL DATA STORAGE UNIT |

102
DESCRIPTOR STORAGE UNIT

103
TRAINING DATA GENERATION UNIT

104
MODEL TRAINING UNIT

105
MODEL STORAGE UNIT

108
EXPLANATORY VARIABLE CALCULATION UNIT

109
PHYSICAL PROPERTY VALUE PREDICTION UNIT

107
CANDIDATE COMPOSITION GENERATION UNIT

106
PROPOSAL CONDITION OBTAINMENT UNIT

110
PROPOSAL INFORMATION GENERATION UNIT

20

201
PROPOSAL CONDITION INPUT UNIT

202
PROPOSAL INFORMATION DISPLAY UNIT

# FIG.8

EP 4 733 840 A1

| FILM | EXPERIMENTAL COMPOSITION | | | | EXPERIMENTAL VALUE | | |
|---|---|---|---|---|---|---|---|
| | ACRYLIC ACID (wt%) | STYRENE (wt%) | THIRD COMPONENT (wt%) | THIRD COM-PONENT | 16 $\mu$ m PITCH ADHESION | RESO-LUTION 3x/x | · · · |
| FILM A | 20 | 60 | 20 | MONOMER A | 3.0 | 7.4 | · · · |
| FILM B | 18 | 72 | 10 | MONOMER B | 2.5 | 5.6 | · · · |
| FILM C | 18 | 80 | 2 | MONOMER C | 1.8 | 6.9 | · · · |
| · · · | · · · | · · · | · · · | · · · | · · · | · · · | · · · |

# FIG.9

| MONOMER | HSP_$\delta$D | NUMBER OF CARBOXYLIC ACIDS | logP | POLYMER Tg (K) | ... |
|---------|---------------|----------------------------|------|----------------|-----|
| MONOMER A | 16.80 | 0.280 | 2.00 | 370 | ... |
| MONOMER B | 17.00 | 0.290 | 2.40 | 380 | ... |
| MONOMER C | 17.20 | 0.260 | 2.20 | 350 | ... |
| ... | ... | ... | ... | ... | ... |

# FIG.10

NUMBER OF CARBOXYLIC ACIDS
HSP_$\delta$D
logP

→ ADHESION PREDICTION MODEL 301

→ 16$\mu$m PITCH ADHESION

# FIG.11

R2=0.95, RMSE=0.72

predict

actual

# FIG.12

NUMBER OF
CARBOXYLIC
ACIDS
HSP_$\delta$ D
POLYMER Tg

→

302

RESOLUTION
PREDICTION
MODEL

→

RESOLUTION
3x/x

# FIG.13

R2=0.83, RMSE=1.03

# FIG.14

```
        START
          │
          ▼                S1
┌──────────────────────┐
│    OBTAIN MONOMER     │
└──────────────────────┘
          │
          ▼
╱──────────────────────╲
│    EACH MONOMER       │
╲──────────────────────╱
          │
          ▼                S2
┌──────────────────────┐
│  CALCULATE DESCRIPTOR │
└──────────────────────┘
          │
          ▼                S3
┌──────────────────────┐
│   STORE DESCRIPTOR    │
└──────────────────────┘
          │
          ▼
╱──────────────────────╲
│    EACH MONOMER       │
╲──────────────────────╱
          │
          ▼
         END
```

# FIG.15

```
         ┌─────────────┐
         │    START    │
         └──────┬──────┘
                │                    S11
         ┌──────▼──────────────────────┐
         │  OBTAIN EXPERIMENTAL DATA    │
         └──────┬──────────────────────┘
                │                    S12
         ┌──────▼──────────────────────┐
         │      OBTAIN DESCRIPTOR       │
         │       OF MONOMER             │
         └──────┬──────────────────────┘
                │                    S13
         ┌──────▼──────────────────────┐
         │        CALCULATE             │
         │  EXPLANATORY VARIABLE        │
         └──────┬──────────────────────┘
                │                    S14
         ┌──────▼──────────────────────┐
         │  PREDICT OBJECTIVE VARIABLE  │
         └──────┬──────────────────────┘
                │
                │◄──────────────────────┐
                │                    S15 │
         ┌──────▼──────────────────────┐│
         │   UPDATE MODEL PARAMETER     ││
         └──────┬──────────────────────┘│
                │                    S16 │
              ◇─▼────────────────◇  NO   │
             ◇  IS TRAINING       ◇──────┘
              ◇  COMPLETED?      ◇
                └───────┬───────┘
                        │ YES
                 ┌──────▼──────┐
                 │     END     │
                 └─────────────┘
```

25

# FIG.16

```
         ┌──────────────────┐                         ┌──────────────────┐
         │  TERMINAL DEVICE │  20                  10 │ PROPOSAL DEVICE  │
         └────────┬─────────┘                         └────────┬─────────┘
                  │                                            │
                  ▼   S21                                      │
         ┌──────────────────┐                                  │
         │  INPUT PROPOSAL  │─────────────────────┐            │
         │    CONDITION     │                     │            ▼   S22
         └────────┬─────────┘                     │   ┌──────────────────┐
                  │                               └──▶│ OBTAIN PROPOSAL  │
                  │                                   │    CONDITION     │
                  │                                   └────────┬─────────┘
                  │                                            ▼   S23
                  │                                   ┌──────────────────┐
                  │                                   │ GENERATE CANDIDATE│
                  │                                   │   COMPOSITION     │
                  │                                   └────────┬─────────┘
                  │                                            ▼
                  │                                   ╱ EACH CANDIDATE  ╲
                  │                                   ╲  COMPOSITION    ╱
                  │                                            ▼   S24
                  │                                   ┌──────────────────┐
                  │                                   │    CALCULATE     │
                  │                                   │EXPLANATORY VARIABLE│
                  │                                   └────────┬─────────┘
                  │                                            ▼   S25
                  │                                   ┌──────────────────┐
                  │                                   │ PREDICT OBJECTIVE│
                  │                                   │    VARIABLE      │
                  │                                   └────────┬─────────┘
                  │                                            ▼   S26
                  │                                        ╱ ARE  ╲      NO
                  │                                  ◇ TARGET PROPERTIES ◇──┐
                  │                                        ╲SATISFIED?╱     │
                  │                                            │ YES        │
                  │                                            ▼   S27      │
                  │                                   ┌──────────────────┐  │
                  │                                   │  ADD TO PROPOSAL │  │
                  │                                   │   INFORMATION    │  │
                  │                                   └────────┬─────────┘  │
                  │                                            ◀────────────┘
                  │                                            ▼
                  │                                   ╱ EACH CANDIDATE  ╲
                  │                                   ╲  COMPOSITION    ╱
                  │                                            ▼   S28
                  │                                   ┌──────────────────┐
                  ◀───────────────────────────────── │TRANSMIT PROPOSAL │
                  │   S29                             │   INFORMATION    │
                  ▼                                   └────────┬─────────┘
         ┌──────────────────┐                                  ▼
         │ DISPLAY PROPOSAL │                            ┌──────────┐
         │    CONDITION     │                            │   END    │
         └────────┬─────────┘                            └──────────┘
                  ▼
            ┌──────────┐
            │   END    │
            └──────────┘
```

26

## INTERNATIONAL SEARCH REPORT

| International application No. |
| --- |
| **PCT/JP2024/021577** |

### A.   CLASSIFICATION OF SUBJECT MATTER

*G03F 7/033*(2006.01)i; *C08F 212/08*(2006.01)i; *G03F 7/004*(2006.01)i
FI:   G03F7/033; G03F7/004 512; C08F212/08

According to International Patent Classification (IPC) or to both national classification and IPC

### B.   FIELDS SEARCHED

Minimum documentation searched (classification system followed by classification symbols)

G03F7/033; C08F212/08; G03F7/004

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

### C.   DOCUMENTS CONSIDERED TO BE RELEVANT

| Category* | Citation of document, with indication, where appropriate, of the relevant passages | Relevant to claim No. |
| --- | --- | --- |
| X | WO 2022/030053 A1 (SHOWA DENKO MATERIALS CO., LTD.) 10 February 2022 (2022-02-10) <br> paragraphs [0024], [0030]-[0031], examples | 1-8 |
| A | JP 2005-257812 A (HITACHI CHEMICAL CO., LTD.) 22 September 2005 (2005-09-22) <br> examples | 1-8 |

☐ Further documents are listed in the continuation of Box C.    ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **01 August 2024** | **13 August 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

INTERNATIONAL SEARCH REPORT
Information on patent family members

International application No.

**PCT/JP2024/021577**

| Patent document cited in search report | | | Publication date (day/month/year) | Patent family member(s) | | | Publication date (day/month/year) |
|---|---|---|---|---|---|---|---|
| WO | 2022/030053 | A1 | 10 February 2022 | US 2023/0273518 A1 paragraphs [0027], [0033]-[0034], examples CN 116209571 A KR 10-2023-0050360 A TW 202206468 A | | | |
| JP | 2005-257812 | A | 22 September 2005 | (Family: none) | | | |

Form PCT/ISA/210 (patent family annex) (July 2022)

**EP 4 733 840 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013216804 A

- JP 2023104223 A